# EUROPEAN PATENT SPECIFICATION

(11) **EP 4 187 625 B1**
(45) Date of publication and mention of the grant of the patent: **11.11.2026**
(21) Application number: 21846804.9
(22) Date of filing: 15.07.2021
(51) Int. Cl.: H10N 10/17, H10N 10/817

(54) **THERMOELECTRIC ELEMENT**
THERMOELEKTRISCHES ELEMENT
ÉLÉMENT THERMOÉLECTRIQUE

(30) Priority: 24.07.2020 KR 20200092525
(43) Date of publication of application: 31.05.2023
(73) Proprietor: LG Innotek Co., Ltd., Seoul 07796 (KR)
(72) Inventor: LEE, Jong Min, Seoul 07796 (KR); LEE, Se Woon, Seoul 07796 (KR); CHOI, Man Hue, Seoul 07796 (KR)
(74) Representative: Plasseraud IP
(86) International application number: PCT/KR2021/009109
(87) International publication number: WO 2022/019569

(56) References cited:
- JP-A- 2004 200 447
- JP-A- 2004 200 447
- JP-A- 2004 303 872
- JP-A- 2004 303 872
- JP-A- 2006 303 017
- JP-A- 2006 303 017
- JP-A- 2008 277 394
- JP-A- 2008 277 394
- KR-A- 20190 035 310
- KR-A- 20190 116 066
- KR-A- 20190 116 066

## Description

### [Technical Field]

The present invention relates to a thermoelectric element, and more specifically, to a structure of an electrode disposed on a substrate.

### [Background Art]

A thermoelectric phenomenon is a phenomenon which occurs due to the movement of electrons and holes in a material, and refers to direct energy conversion between heat and electricity.

A thermoelectric element is a generic term for an element using the thermoelectric phenomenon and has a structure in which a P-type thermoelectric material and an N-type thermoelectric material are joined between metal electrodes to form a PN junction pair.

Thermoelectric elements can be classified into an element using temperature changes of electrical resistance, an element using the Seebeck effect, which is a phenomenon in which an electromotive force is generated due to a temperature difference, an element using the Peltier effect, which is a phenomenon in which heat absorption or heat generation by current occurs, and the like.

The thermoelectric element is variously applied to home appliances, electronic components, communication components, or the like. For example, the thermoelectric element can be applied to a cooling device, a heating device, a power generation device, or the like. Accordingly, the demand for thermoelectric performance of the thermoelectric element is increasing more and more.

In this case, the thermoelectric element has a problem in that electrical reliability between an electrode and a thermoelectric leg is lowered and power generation performance is lowered.

Documents JP 2004/200447 A, KR 2019/0116066 A, JP 2005/303017 A and KR 2019/0035310 A describe examples of thermoelectric elements.

### [Disclosure]

### [Technical Problem]

The present invention is directed to providing a structure of an electrode of a thermoelectric element for improving electrical reliability.

### [Technical Solution]

To this end, the invention relates to a thermoelectric element according to claim 1. The thermoelectric element may present one or more of the features of dependent claims 2 to 15.

### [Advantageous Effects]

According to an embodiment of the present invention, a thermoelectric element having improved power generation and high electrical reliability, and a thermoelectric device including the same can be acquired.

Specifically, according to the embodiment of the present invention, a thermoelectric element having a barrier portion formed toward a thermoelectric leg so that an electrode surrounds the thermoelectric leg adjacent thereto can be provided.

A thermoelectric element according to the embodiment of the present invention can be applied not only to an application implemented in a small size but also to an application implemented in a large size such as a vehicle, a ship, a steel mill, an incinerator, or the like.

### [Description of Drawings]

FIG. 1 is a cross-sectional view of a thermoelectric element.
FIG. 2 is a perspective view of the thermoelectric element.
FIG. 3 is a perspective view of the thermoelectric element including a sealing member.
FIG. 4 is an exploded perspective view of the thermoelectric element including the sealing member.
FIG. 5 is a cross-sectional view of a thermoelectric element according to one embodiment.
FIG. 6 is a view illustrating an electrical connection between a first electrode and a second electrode and semiconductor structures according to one embodiment.
FIG. 7 is a plan view of a first electrode, a first conductive bonding member, and semiconductor structures according to one embodiment.
FIG. 8 is an enlarged view of portion P in FIG. 5.
FIG. 9 is a cross-sectional view taken along line I-I' in FIG. 7.
FIG. 10 is a cross-sectional view of a thermoelectric element according to another embodiment.
FIG. 11 is an enlarged view of portion K in FIG. 10.

### [Modes of the Invention]

Hereinafter, one preferable embodiment of the present invention will be described in detail with reference to the accompanying drawings.

Further, terms used in the embodiments of the present invention (including technical and scientific terms), may be interpreted with meanings that are generally understood by those skilled in the art unless particularly defined and described, and terms which are generally used, such as terms defined in a dictionary, may be understood in consideration of their contextual meanings in the related art.

In addition, terms used in the description are provided not to limit the present invention but to describe the embodiments.

In the specification, the singular form may also include the plural form unless the context clearly indicates otherwise and may include one or more of all possible combinations of A, B, and C when disclosed as at least one (or one or more) of "A, B, and C."

In addition, terms such as first, second, A, B, (a), (b), and the like may be used to describe elements of the embodiments of the present invention.

Such terms are only provided to distinguish the elements from other elements, and the essence, sequence, order, or the like of the elements are not limited by the terms.

Further, when particular elements are disclosed as being "connected," "coupled," or "linked" to other elements, the elements may include not only a case of being directly connected, coupled, or linked to other elements but also a case of being connected, coupled, or linked to other elements by elements between the elements and other elements.

In addition, when one element is disclosed as being formed "on or under" another element, the term "on or under" includes both a case in which the two elements are in direct contact with each other and a case in which at least another element is disposed between the two elements (indirect contact). Further, when the term "on or under" is expressed, a meaning of not only an upward direction but also a downward direction may be included based on one element.

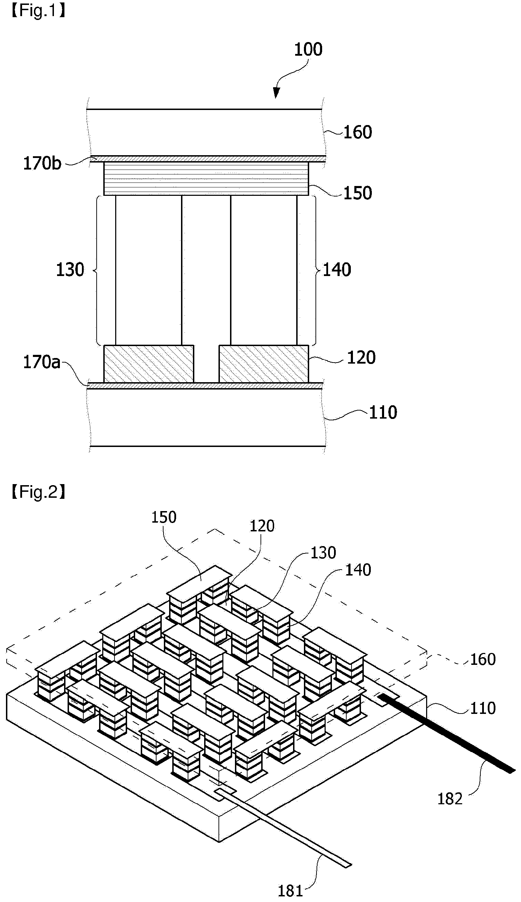

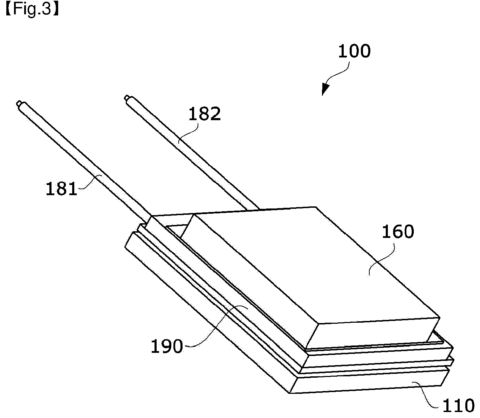

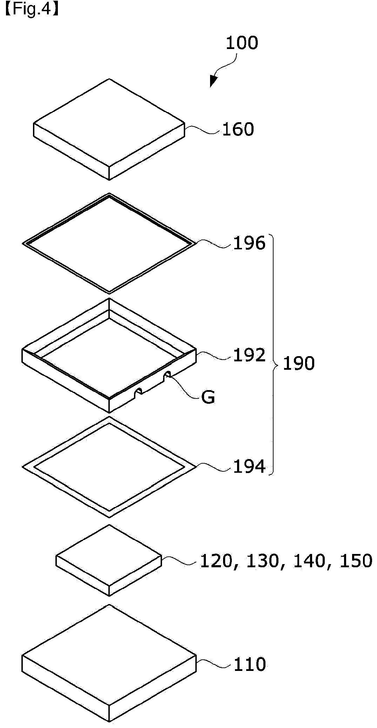

FIG. 1 is a cross-sectional view of a thermoelectric element, FIG. 2 is a perspective view of the thermoelectric element, FIG. 3 is a perspective view of the thermoelectric element including a sealing member, FIG. 4 is an exploded perspective view of the thermoelectric element including the sealing member.

Referring to FIGS. 1 and 2, a thermoelectric element 100 includes a lower substrate 110, lower electrodes 120, a P-type thermoelectric leg 130, an N-type thermoelectric leg 140, an upper electrode 150, and an upper substrate 160.

The lower electrodes 120 are disposed between the lower substrate 110 and lower bottom surfaces of the P-type thermoelectric leg 130 and the N-type thermoelectric leg 140, and the upper electrode 150 is disposed between the upper substrate 160 and upper bottom surfaces of the P-type thermoelectric leg 130 and the N-type thermoelectric leg 140. Accordingly, a plurality of P-type thermoelectric legs 130 and a plurality of N-type thermoelectric legs 140 are electrically connected by the lower electrodes 120 and the upper electrode 150. One pair of the P-type thermoelectric leg 130 and the N-type thermoelectric leg 140 which are disposed between the lower electrodes 120 and the upper electrode 150 and electrically connected to each other may form a unit cell. The P-type thermoelectric leg 130 may be a second conductive semiconductor structure or a second semiconductor structure, and the N-type thermoelectric leg 140 may be a first conductive semiconductor structure or a first semiconductor structure. Alternatively, the above-described words may be used interchangeably. Further, the plurality of semiconductor structures may include the above-described first conductive semiconductor structure and second conductive semiconductor structure. In addition, the lower electrodes 120 are used interchangeably with first electrodes. In addition, the upper electrode 150 to be described below is used interchangeably with a second electrode.

For example, when a voltage is applied to the lower electrodes 120 and the upper electrodes 150 through lead lines 181 and 182, a substrate through which current flows from the P-type thermoelectric legs 130 to the N-type thermoelectric legs 140 due to the Peltier effect may absorb heat and act as a cooling unit, and a substrate through which current flows from the N-type thermoelectric legs 140 to the P-type thermoelectric legs 130 may be heated and act as a heating unit. Alternatively, when a temperature difference between the lower electrode 120 and the upper electrode 150 is applied, electric charges in the P-type thermoelectric leg 130 and the N-type thermoelectric leg 140 may move due to the Seebeck effect, and thus electricity may be generated.

Although FIGS. 1 to 4 illustrate that the lead lines 181 and 182 are disposed on the lower substrate 110, the present invention is not limited thereto, and the lead lines 181 and 182 may be disposed on the upper substrate 160 or the lower substrate 110, or one of the lead lines 181 and 182 may be disposed on the lower substrate 110 and the other may be disposed on the upper substrate 160.

Further, the lead lines may be connected to the low-temperature portion side of the thermoelectric element 100. In addition, equipment for an application to which the thermoelectric element 100 is applied may be mounted on the high-temperature portion side of the thermoelectric element 100. For example, when the thermoelectric element 100 is applied, ship equipment may be mounted on the high-temperature portion side of the thermoelectric element 100. Accordingly, withstand voltage performance may be required for both the low-temperature portion side and the high-temperature portion side of the thermoelectric element 100. For example, when the thermoelectric element 100 is driven, a temperature of the high-temperature portion may be relatively higher than a temperature of the low-temperature portion.

Meanwhile, higher thermal conductivity may be required at the high-temperature portion side of the thermoelectric element 100 compared to the low-temperature portion side of the thermoelectric element 100. A copper substrate has higher thermal conductivity and higher electrical conductivity compared to an aluminum substrate. In order to satisfy both thermal conductivity performance and withstand voltage performance, among the first substrate 110 and the second substrate 160, the substrate disposed on the low-temperature portion side of the thermoelectric element 100 may be an aluminum substrate, and the substrate disposed on the high-temperature portion side of the thermoelectric element 100 may be a copper substrate. However, since the electrical conductivity of the copper substrate is higher than the electrical conductivity of the aluminum substrate, a separate configuration may be required to maintain the withstand voltage performance of the high-temperature portion side of the thermoelectric element 100.

Here, the P-type thermoelectric leg 130 and the N-type thermoelectric leg 140 may be bismuth-telluride (Bi-Te)-based thermoelectric legs including bismuth (Bi) and tellurium (Te) as main raw materials. The P-type thermoelectric leg 130 may be a bismuth-telluride (Bi-Te)-based thermoelectric leg including at least one of antimony (Sb), nickel (Ni), aluminum (Al), copper (Cu), silver (Ag), lead (Pb), boron (B), gallium (Ga), tellurium (Te), bismuth (Bi), and indium (In). For example, the P-type thermoelectric leg 130 may include Bi-Sb-Te, which is a main raw material, in an amount of 99 to 99.999 wt%, and may include at least one of nickel (Ni), aluminum (Al), copper (Cu), silver (Ag), lead (Pb), boron (B), gallium (Ga), and indium (In) in an amount of 0.001 to 1 wt% based on 100 wt% of the total weight. The N-type thermoelectric leg 140 may be a bismuth-telluride (Bi-Te)-based thermoelectric leg including at least one of selenium (Se), nickel (Ni), aluminum (Al), copper (Cu), silver (Ag), lead (Pb), boron (B), gallium (Ga), tellurium (Te), bismuth (Bi), and indium (In). For example, the N-type thermoelectric leg 140 may include Bi-Se-Te, which is a main raw material, in an amount of 99 to 99.999 wt%, and may include at least one of nickel (Ni), aluminum (Al), copper (Cu), silver (Ag), lead (Pb), boron (B), gallium (Ga), and indium (In) in an amount of 0.001 to 1 wt% based on 100 wt% of the total weight. Accordingly, in the present specification, the thermoelectric leg may also be referred to as a semiconductor structure, a semiconductor element, a semiconductor matter layer, a semiconductor substance layer, a semiconductor material layer, a conductive semiconductor structure, a thermoelectric structure, a thermoelectric matter layer, a thermoelectric substance layer, a thermoelectric material layer, or the like.

The P-type thermoelectric leg 130 and the N-type thermoelectric leg 140 may be formed in a bulk type or a stacked type. Generally, the bulk type P-type thermoelectric leg 130 or the bulk type N-type thermoelectric leg 140 may be acquired through a process of manufacturing an ingot by heat-treating a thermoelectric material, acquiring powder for thermoelectric legs by pulverizing and sieving the ingot, sintering the powder, and then cutting a sintered object. In this case, the P-type thermoelectric leg 130 and the N-type thermoelectric leg 140 may be polycrystalline thermoelectric legs. Like the above, when the P-type thermoelectric leg 130 and the N-type thermoelectric leg 140 are polycrystalline thermoelectric legs, the strength of the P-type thermoelectric leg 130 and the N-type thermoelectric leg 140 may be improved. The stacked type P-type thermoelectric leg 130 or the stacked type N-type thermoelectric leg 140 may be acquired through a process of forming a unit member by applying a paste including a thermoelectric material on a sheet-shaped base material, and then stacking and cutting the unit member

In this case, one pair of the P-type thermoelectric leg 130 and the N-type thermoelectric leg 140 may have the same shape and volume or may have different shapes and volumes. For example, since electrical conduction characteristics of the P-type thermoelectric leg 130 and the N-type thermoelectric leg 140 are different, a height or cross-sectional area of the N-type thermoelectric leg 140 may be formed differently from a height or cross-sectional area of the P-type thermoelectric leg 130.

In this case, the P-type thermoelectric leg 130 or the N-type thermoelectric leg 140 may have a cylindrical shape, a polygonal columnar shape, an elliptical columnar shape, or the like.

Alternatively, the P-type thermoelectric leg 130 or the N-type thermoelectric leg 140 may have a stacked structure. For example, the P-type thermoelectric leg 130 or the N-type thermoelectric leg 140 may be formed using a method of stacking a plurality of structures in which a semiconductor material is applied on a sheet-shaped base material and then cutting the structures. Accordingly, material loss may be prevented and electrical conduction characteristics may be improved. Each structure may further include a conductive layer having an opening pattern, and accordingly, an adhesive force between the structures may be improved, thermal conductivity may be lowered, and electrical conductivity may be improved.

Alternatively, the P-type thermoelectric leg 130 or the N-type thermoelectric leg 140 may be formed to have different cross-sectional areas in one thermoelectric leg. For example, cross-sectional areas of both end portions disposed to face an electrode in one thermoelectric leg may be formed to be larger than a cross-sectional area between the both end portions. Accordingly, since a large temperature difference between both end portions may be formed, thermoelectric efficiency may be improved.

The performance of the thermoelectric element according to one embodiment of the present invention may be expressed as a thermoelectric figure of merit (ZT). The thermoelectric figure of merit (ZT) may be expressed as in Equation 1. [Equation 1] $ZT = {α}^{2} ⋅ σ ⋅ T / k$

Here, α denotes the Seebeck coefficient [V/K], α denotes electrical conductivity [S/m], and α²σ denotes a power factor (W/mK²]). Further, T denotes temperature, and k denotes thermal conductivity [W/mK]. k may be expressed as a•cp•ρ, wherein a denotes thermal diffusivity [cm²/S], cp denotes specific heat [J/gK], and ρ denotes density [g/cm³].

In order to acquire the thermoelectric figure of merit of the thermoelectric element, a Z value (V/K) may be measured using a Z meter, and the thermoelectric figure of merit (ZT) may be calculated using the measured Z value.

Here, each of the lower electrodes 120 disposed between the lower substrate 110 and the P-type thermoelectric leg 130 and the N-type thermoelectric leg 140 and the upper electrode 150 disposed between the upper substrate 160 and the P-type thermoelectric leg 130 and the N-type thermoelectric leg 140 may include at least one of copper (Cu), silver (Ag), aluminum (Al), and nickel (Ni), and may have a thickness of 0.01 mm to 0.3 mm. When the thickness of the lower electrode 120 or the upper electrode 150 is smaller than 0.01 mm, the function as an electrode may be deteriorated and the electrical conduction performance may be lowered, and when the thickness of the lower electrode 120 or the upper electrode 150 exceeds 0.3 mm, conduction efficiency may be lowered due to an increase in resistance.

Further, the lower substrate 110 and the upper substrate 160 facing each other may be metal substrates, and each thickness thereof may be 0.1 mm to 1.5 mm. When the thickness of the metal substrate is smaller than 0.1 mm or exceeds 1.5 mm, since heat dissipation characteristics or thermal conductivity may be excessively high, the reliability of the thermoelectric element may be deteriorated. Further, when the lower substrate 110 and the upper substrate 160 are metal substrates, a first insulating part 170a and a second insulating part 170b may be further formed between the lower substrate 110 and the lower electrode 120 and between the upper substrate160 and the upper electrode 150, respectively. The first insulating part 170a and the second insulating part 170b may each include a material having a thermal conductivity of 1 to 20 W/mK.

In this case, the lower substrate 110 and the upper substrate 160 may be formed to have different sizes. For example, a volume, thickness, or area of one of the lower substrate 110 and the upper substrate 160 may be formed to be larger than a volume, thickness, or area of the other. Accordingly, it is possible to improve the heat absorption performance or heat dissipation performance of the thermoelectric element. For example, at least one of a volume, a thickness, and an area of a substrate disposed in a high temperature region for the Seebeck effect, applied as a heating region for the Peltier effect, or on which a sealing member for protecting the thermoelectric module from an external environment is disposed may be larger than at least one of a volume, a thickness, and an area of the other substrate.

Further, a heat dissipation pattern, for example, a concavo-convex pattern may be formed on the surface of at least one of the lower substrate 110 and the upper substrate 160. Accordingly, the heat dissipation performance of the thermoelectric element may be improved. When the concavo-convex pattern is formed on the surface which comes into contact with the P-type thermoelectric leg 130 or the N-type thermoelectric leg 140, bonding characteristics between the thermoelectric leg and the substrate may also be improved. The thermoelectric element 100 includes the lower substrate 110, the lower electrodes 120, the P-type thermoelectric leg 130, the N-type thermoelectric leg 140, the upper electrode 150, and the upper substrate 160.

As shown in FIGS. 3 and 4, a sealing member 190 may be further disposed between the lower substrate 110 and the upper substrate 160. The sealing member 190 may be disposed on side surfaces of the lower electrodes 120, the P-type thermoelectric legs 130, the N-type thermoelectric legs 140, and the upper electrodes 150 between the lower substrate 110 and the upper substrate 160. Accordingly, the lower electrodes 120, the P-type thermoelectric legs 130, the N-type thermoelectric legs 140, and the upper electrodes 150 may be sealed from external moisture, heat, contamination, and the like. Here, the sealing member 190 may include a sealing case 192 disposed to be spaced apart a predetermined distance from outermost side surfaces of the plurality of lower electrodes 120, the plurality of P-type thermoelectric legs 130 and the plurality of N-type thermoelectric legs 140, and the plurality of upper electrodes 150, a sealing material 194 disposed between the sealing case 192 and the lower substrate 110, and a sealing material 196 disposed between the sealing case 192 and the upper substrate 160. Like the above, the sealing case 192 may come into contact with the lower substrate 110 and the upper substrate 160 through the sealing materials 194 and 196. Accordingly, when the sealing case 192 comes into direct contact with the lower substrate 110 and the upper substrate 160, heat conduction occurs through the sealing case 192, and as a result, a problem in that a temperature difference between the lower substrate 110 and the upper substrate 160 is lowered may be prevented. Here, the sealing materials 194 and 196 may include at least one of an epoxy resin and a silicone resin, or a tape in which at least one of the epoxy resin and the silicone resin is applied on both surfaces. The sealing materials 194 and 194 may serve to seal between the sealing case 192 and the lower substrate 110 and between the sealing case 192 and the upper substrate 160, may improve a sealing effect of the lower electrodes 120, the P-type thermoelectric legs 130, the N-type thermoelectric legs 140, and the upper electrodes 150, and may be used interchangeably with a finishing material, a finishing layer, a waterproofing material, a waterproofing layer, and the like. Here, the sealing material 194 which seals between the sealing case 192 and the lower substrate 110 is disposed on an upper surface of the lower substrate 110, and the sealing material 196 which seals between the sealing case 192 and the upper substrate 160 may be disposed on side surfaces of the upper substrate 160. Meanwhile, a guide groove G for drawing out the lead lines 180 and 182 connected to the electrodes may be formed in the sealing case 192. To this end, the sealing case 192 may be an injection-molded product formed of plastic or the like, and may be used interchangeably with a sealing cover. However, the above description of the sealing member is only an example, and the sealing member may be modified into various forms. Although not shown in the drawings, a thermal insulating material may be further included to surround the sealing member. Alternatively, the sealing member may include a thermal insulating component.

In the above, although the terms "lower substrate 110, lower electrode 120, upper electrode 150, and upper substrate 160" are used, they are only arbitrarily referred to as upper and lower portions for ease of understanding and convenience of description, and positions may be reversed so that the lower substrate 110 and the lower electrode 120 may be disposed at an upper portion, and the upper electrode 150 and the upper substrate 160 may be disposed at a lower portion. Further, the upper electrode 150 is used interchangeably with the second electrodes. In addition, the lower substrate may be used interchangeably with 'a first substrate' and the upper substrate may be used interchangeably with 'a second substrate.' In the present specification, a first direction (an X-axis direction) may include a direction X1 toward the second substrate from the first substrate and a direction X2 opposite the direction X1, and the first direction (the X-axis direction) may be used as 'a vertical direction.' Further, the first electrode and the second electrode may be plural.

Meanwhile, as described above, in order to improve the thermal conductivity of the thermoelectric element, attempts for using a metal substrate are increasing. However, when the thermoelectric element includes a metal substrate, an advantageous effect may be acquired in terms of thermal conduction, but there is a problem in that a withstand voltage is lowered. Specifically, when the thermoelectric element is applied under a high voltage condition, withstand voltage performance of 2.5 kV or more is required. In order to improve the withstand voltage performance of the thermoelectric element, a plurality of first insulating parts and second insulating parts having different compositions may be disposed between the metal substrate and the electrodes. However, due to low interfacial adhesion between the plurality of first insulating parts and second insulating parts, shear stress due to a difference in the coefficient of thermal expansion between the plurality of first insulating parts and second insulating parts may occur when the first insulating parts and the second insulating parts are exposed to a high temperature such as in a reflow environment. Accordingly, an air cap may be generated by the destruction of bonding of the interface between the plurality of first insulating parts and second insulating parts. The air cap at the interface between the plurality of first insulating parts and second insulating parts may increase the thermal resistance of the substrate, and accordingly, a temperature difference between both ends of the thermoelectric element may be reduced, and power generation performance of a power generator may be reduced when the thermoelectric element is applied to a power generator.

According to the embodiment of the present invention, a thermoelectric element of which both thermal conductivity performance and withstand voltage performance are improved is acquired by improving the bonding strength of the interface between the plurality of first insulating parts and second insulating parts. Further, a thermoelectric element whose electrical reliability is improved is acquired.

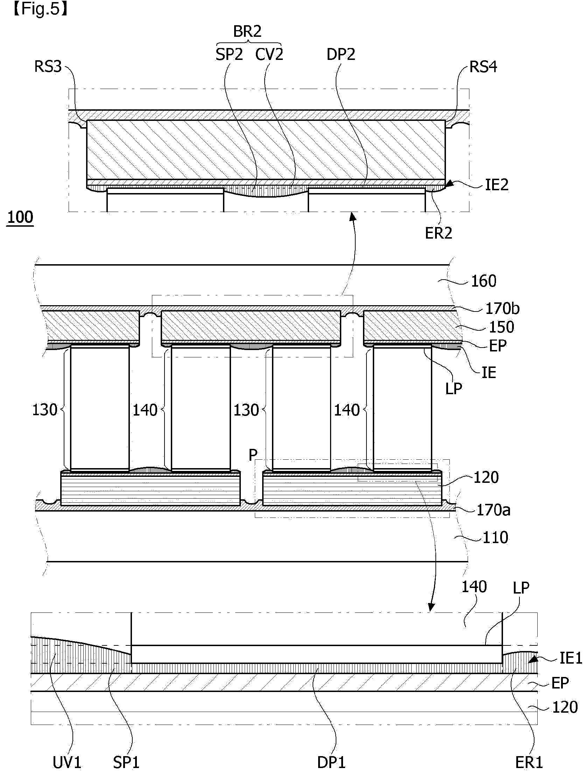

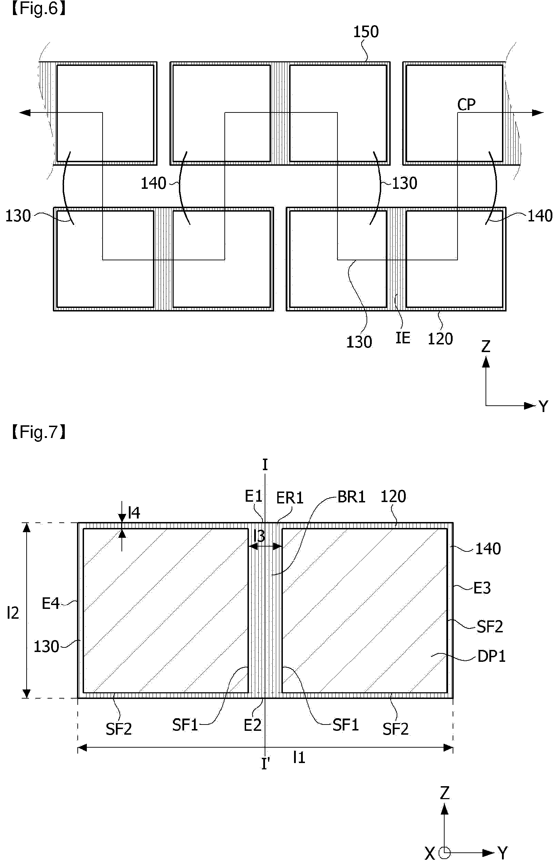

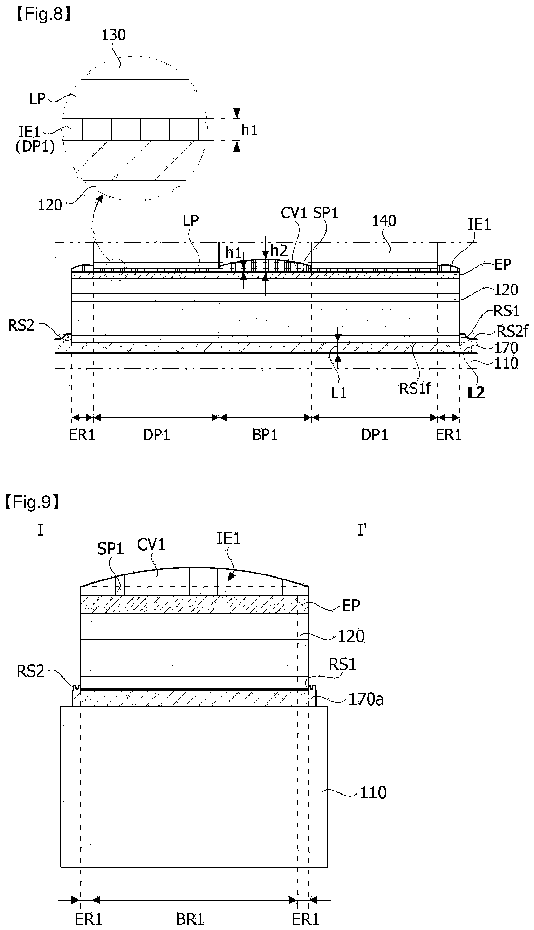

FIG. 5 is a cross-sectional view of a thermoelectric element according to one embodiment, FIG. 6 is a view illustrating an electrical connection between the first electrode and the second electrode and the semiconductor structures according to one embodiment, FIG. 7 is a plan view of the first electrode, the first conductive bonding member, and the semiconductor structures according to one embodiment, FIG. 8 is an enlarged view of portion P in FIG. 5, and FIG. 9 is a cross-sectional view taken along line I-I' in FIG. 7.

Referring to FIG. 5, the thermoelectric element 100 according to one embodiment may include a first substrate 110, a first insulating part 170a (or 'lower insulating part') disposed on the first substrate 110, first electrodes 120 disposed on the first insulating part 170a, a plurality of semiconductor structures 130 and 140 disposed on the first electrodes 120, second electrodes 150 disposed on the plurality of semiconductor structures 130 and 140, a second insulating part 170b (or 'upper insulating part') disposed on the second electrodes 150, and a second substrate 160 disposed on the second insulating part 170b.

In an embodiment, the plurality of semiconductor structures 130 and 140 may include a plurality of first conductive semiconductor structures (N-type thermoelectric legs) and second conductive semiconductor structures (P-type thermoelectric legs). Further, the first conductive semiconductor structure 130 may be any one of the N-type thermoelectric leg and the P-type thermoelectric leg, and the second conductive semiconductor structure 140 may be the other of the N-type thermoelectric leg and the P-type thermoelectric leg. Hereinafter, description will be made based on the first conductive semiconductor structure as a P-type thermoelectric leg, and the second conductive semiconductor structure as an N-type thermoelectric leg.

Further, descriptions of the first substrate 110, the first electrodes 120, the first conductive semiconductor structures or the P-type thermoelectric legs 130, the second conductive semiconductor structures or the N-type thermoelectric legs 140, the second electrodes 150, and the second substrate 160 in FIGS. 1 to 4 may be equally applied to the first substrate 110, the plurality of semiconductor structures 130 and 140, the second electrodes 150, and the second substrate 160.

Furthermore, although not shown in the drawings, a heat sink may be further disposed on the first substrate 110 or the second substrate 160, and a sealing member may be further disposed between the first substrate 110 and the second substrate 160.

The thermoelectric element 100 according to one embodiment may include the first insulating part 170a disposed on the first substrate 110 and the second insulating part 170b disposed under the second substrate 160. Further, the first insulating part 170a may be disposed on lower surfaces of the first electrodes 120 and the second insulating part 170b may be disposed on upper surfaces of the second electrodes 150. Furthermore, the first substrate 110 may be disposed on a lower surface of the first insulating part 170a, and the second substrate 160 may be disposed on an upper surface of the second insulating part 170b.

The first insulating part 170a and the second insulating part 170b may each be formed of at least one layer. In an embodiment, the first insulating part 170a and the second insulating part 170b may include a first layer and a second layer. That is, the first insulating part and the second insulating part may each include the first layer and the second layer. The first layer may come into contact with the first substrate or the second substrate, and the second layer may come into contact with the first electrode or the second electrode.

In this case, the first layer may include a composite including silicon and aluminum. Here, the composite may be an organic-inorganic composite composed of an inorganic substance including an Si element and an Al element and an alkyl chain, and may be at least one of an oxide, carbide, and nitride including silicon and aluminum. For example, the composite may include at least one of an Al-Si bond, an Al-O-Si bond, an Si-O bond, an Al-Si-O bond, and an Al-O bond. Like the above, the composite including at least one of the Al-Si bond, the Al-O-Si bond, the Si-O bond, the Al-Si-O bond, and the Al-O bond may have excellent insulation performance, and accordingly, high withstand voltage performance may be acquired. Alternatively, the composite may be an oxide, carbide, or nitride further including titanium, zirconium, boron, zinc, etc. along with silicon and aluminum. To this end, the composite may be acquired through a process of heat treatment after mixing at least one of an inorganic binder and an organic-inorganic mixed binder with aluminum. The inorganic binder may include, for example, at least one of silica (SiO₂), a metal alkoxide, a boron oxide (B₂O₃), and a zinc oxide (ZnO₂). The inorganic binder is an inorganic particle, but may form a sol or gel to serve as a binder when coming into contact with water. In this case, at least one of the silica (SiO₂), the metal alkoxide, and the boron oxide (B₂O₃) serves to increase adhesion between aluminum or with the first substrate (or the second substrate), and the zinc oxide (ZnO₂) may serve to increase the strength of the first layer and increase thermal conductivity.

Meanwhile, the second layer may be formed of a resin layer including at least one of an epoxy resin composition including an epoxy resin and an inorganic filler and a silicone resin composition including polydimethylsiloxane (PDMS). Accordingly, the second layer may improve an insulating property, bonding strength, and thermal conductivity between the first layer and the first electrode (or between the first layer and the second electrode).

Here, the inorganic filler may be included in an amount of 60wt% to 80wt% of the resin layer. When the inorganic filler is included in an amount less than 60wt%, thermal conductivity may be low, and when the inorganic filler is included in an amount more than 80wt%, it may be difficult to uniformly disperse the inorganic filler in the resin, and the resin layer may be easily broken.

Further, the epoxy resin may include an epoxy compound and a curing agent. In this case, the curing agent may be included in a volume ratio of 1 to 10 based on a volume ratio of 10 of the epoxy compound. Here, the epoxy compound may include at least one of a crystalline epoxy compound, an amorphous epoxy compound, and a silicone epoxy compound. The inorganic filler may include at least one of aluminum oxide and nitride. Here, the nitride may include at least one of boron nitride and aluminum nitride.

In this case, a particle size D50 of a boron nitride agglomerate may be 250 µm to 350 µm, and a particle size D50 of the aluminum oxide may be 10 µm to 30 µm. When the particle size D50 of the boron nitride agglomerate and the particle size D50 of the aluminum oxide satisfy these numerical ranges, the boron nitride agglomerate and the aluminum oxide may be uniformly dispersed in the resin layer, and accordingly, the resin layer may have a uniform heat conduction effect and uniform adhesion performance as a whole.

When the second layer is a resin composition including a polydimethylsiloxane (PDMS) resin and aluminum oxide, the content (for example, a weight ratio) of silicon in the first layer may be higher than the content of silicon in the second layer, and the content of aluminum in the second layer may be higher than the content of aluminum in the first layer. Accordingly, silicon in the first layer may mainly contribute to an improvement in withstand voltage performance, and aluminum oxide in the second layer may mainly contribute to an improvement in thermal conductivity performance. Accordingly, both the first layer and the second layer have insulation performance and thermal conductivity performance, and the withstand voltage performance of the first layer may be higher than the withstand voltage performance of the second layer, and the thermal conductivity performance of the second layer may be higher than the thermal conductivity performance of the first layer.

Meanwhile, the compositions of the first layer and the second layer are different from each other, and accordingly, at least one of the hardness, modulus of elasticity, tensile strength, elongation rate, and Young's modulus of the first and second layers may vary, and accordingly, it is possible to control withstand voltage performance, thermal conductivity performance, bonding performance, thermal shock alleviation performance, and the like.

Further, the thermoelectric element 100 according to one embodiment further includes first blocking layers LP disposed at both ends of the plurality of semiconductor structures 130 and 140, and may include a second blocking layer EP disposed on the first electrode 120 or the second electrode 150, and a first conductive bonding member IE1 and a second conductive bonding member IE2 disposed between the first blocking layers LP and the second blocking layer EP. The first conductive bonding member may be disposed between the plurality of semiconductor structures 130 and 140 and the first electrodes 120, and the second conductive bonding member IE2 may be disposed between the plurality of semiconductor structures 130 and 140 and the second electrodes 150. Alternatively, the first conductive bonding member IE1 may be disposed on the first electrodes 120 and the second conductive bonding member IE2 may be disposed under the second electrodes 150.

Further, the first blocking layers LP may be disposed at both ends of the plurality of semiconductor structures 130 and 140. In an embodiment, the first blocking layers LP may be positioned at both ends of the first conductive semiconductor structure 130 and both ends of the second conductive semiconductor structure 140. Accordingly, the first blocking layers LP may come into contact with the plurality of semiconductor structures 130 and 140.

Further, the first blocking layers LP are positioned between the first electrodes 120 and the plurality of semiconductor structures 130 and 140 and between the second electrodes 150 and the plurality of semiconductor structures 130 and 140, and thus may also come into contact with the first electrodes 120 or the second electrodes 150.

The first blocking layer LP may be formed of metal. For example, the first blocking layer LP may include nickel (Ni). The first blocking layer LP may prevent the movement or migration of a component (for example, Cu) of the first electrode and a component (for example, Sn) of the first conductive bonding member IE1 to be described below to the semiconductor structures 130 and 140. According to this configuration, for example, as tin (Sn) of the first conductive bonding member IE1 moves to the semiconductor structures 130 and 140 and thus a gap is formed in a region where the first conductive bonding member IE1 and the first electrode 120 come into contact with each other, a problem in that an electrical connection between the semiconductor structure and the first electrode 120 is disconnected or open may be prevented. In other words, the first blocking layer LP may prevent the components of the first electrode 120 or the components of the first conductive bonding member IE1 from moving to stably maintain the electrical connection between the semiconductor structure and the first electrode. Accordingly, the electrical reliability of the thermoelectric element may be improved.

The second blocking layer EP may be positioned on the first electrode 120 or the second electrode 150. In an embodiment, one surface of the second blocking layer EP may come into contact with the first electrode 120. Further, the second blocking layer EP may be positioned between the first electrode 120 and the semiconductor structures 130 and 140 or between the first electrode 120 and the first conductive bonding member IE1. In an embodiment, the other surface of the second blocking layer EP may come into contact with the first conductive bonding member IE1.

The second blocking layer EP may be formed of metal like the first blocking layer LP. For example, the second blocking layer EP may include nickel (Ni). The second blocking layer EP may prevent the components of the first electrode 120 from moving to the semiconductor structures 130 and 140. Accordingly, components (for example, BiTe) of the semiconductor structures 130 and 140 and components (for example, Sn) of the first conductive bonding member may be bonded to each other at a predetermined temperature (for example, a high temperature) to form SnTe. According to this configuration, a problem in that the components of the first electrode 120 move to the semiconductor structures 130 and 140 and a bonding area between the first electrode 120 and the second blocking layer EP is reduced and thus an electrical connection is disconnected may be prevented. That is, the second blocking layer EP may prevent the movement of the first electrode 120 to stably maintain the electrical connection between the semiconductor structure and the first electrode. Accordingly, the electrical reliability of the thermoelectric element may be improved.

The first conductive bonding member IE1 may be disposed between the first blocking layer LP and the second blocking layer EP to couple the first blocking layer LP and the second blocking layer EP. Further, the first conductive bonding member IE1 may be positioned between the semiconductor structures 130 and 140 and the first electrode 120, and the second conductive bonding member IE may be positioned between the semiconductor structures 130 and 140 and the second electrode 150. Accordingly, the first conductive bonding member IE1 may couple the semiconductor structures 130 and 140 and the first electrode 120, and the second conductive bonding member IE2 may couple the semiconductor structures 130 and 140 and the second electrode 150.

Further, the first conductive bonding member IE1 and the second conductive bonding member IE2 may each include a metal component. For example, the first conductive bonding member IE1 may include tin (Sn). Further, the first conductive bonding member IE1 may have conductivity like the first and second blocking layers LP and EP.

In an embodiment, in the first conductive bonding member IE1, a height at regions outside edges of the semiconductor structures and a height at lower regions (regions overlapping in a vertical direction) of the semiconductor structures 130 and 140 may be different from each other. For example, in the first conductive bonding member IE1, the height at the regions outside the edges of the semiconductor structures may be greater than the height at the lower regions (regions overlapping in the vertical direction) of the semiconductor structures 130 and 140.

In an embodiment, the first conductive bonding member IE2 may include first arrangement portions DP1 on which the plurality of semiconductor structures 130 and 140 are respectively disposed, and a first barrier portion BR1 disposed between the first arrangement portions DP1 or between the semiconductor structures.

Further, the first barrier portion BR1 may include a first support SP1 having the same thickness as the first arrangement portion DP1, and a first convex portion CV1 which is disposed on the first support SP1 and convex in a direction toward the first insulating part 170a from the first substrate 110.

In addition, in the second conductive bonding member IE2, a height at regions outside edges of the semiconductor structures and a height at upper regions (regions overlapping in a vertical direction) of the semiconductor structures 130 and 140 may be different from each other. For example, in the second conductive bonding member IE2, the height at the regions outside the edges of the semiconductor structures may be greater than the height at the upper regions (regions overlapping in the vertical direction) of the semiconductor structures 130 and 140.

In an embodiment, the second conductive bonding member IE2 may include second arrangement portions DP2 on which the plurality of semiconductor structures 130 and 140 are respectively disposed, and a second barrier portion BR2 disposed between the second arrangement portions DP2 or between the semiconductor structures 130 and 140.

Further, the second barrier portion BR2 may include a second support SP2 having the same thickness as the second arrangement portion DP2, and a second convex portion CV2 which is disposed under the second support SP2 and convex in a direction toward the second insulating part 170b from the second substrate 160. A detailed description thereof will be described later.

Referring to FIGS. 6 and 7, the first electrodes 120 and the second electrodes 150 may be electrically connected to each other through the semiconductor structures 130 and 140. Accordingly, a current may sequentially flow through the second electrode 150, the first conductive semiconductor structure 130, the first electrode 120, and the second conductive semiconductor structure 140 (CP).

Further, as described above, the first conductive semiconductor structure 130 and the second semiconductor structure 140 may be positioned on the first electrode 120 and the second electrode 150. Although description is based on the first electrode 120, the same may be applied to the second electrode 150. Further, the first conductive semiconductor structure 130 and the second semiconductor structure 140 may be disposed to be spaced apart from each other in a second direction (a Y-axis direction). This second direction (the Y-axis direction) may be perpendicular to the above-described vertical direction or first direction (X-axis direction). Further, a third direction (a Z-axis direction) may be a direction perpendicular to the second direction (the Y-axis direction) and the first direction (the X-axis direction). The following descriptions will be described based on this.

In the first electrode 120, a length l1 in the second direction (the Y-axis direction) may be greater than a length l2 in the third direction (the Z-axis direction). For example, the first electrode 120 may have a rectangular shape on a YZ plane.

In an embodiment, the first electrode 120 may include a first edge surface E1, a second edge surface E2, a third edge surface E3, and a fourth edge surface E4. The first edge surface E1, the second edge surface E2, the third edge surface E3, and the fourth edge surface E4 may be outer surfaces of the first electrode 120. That is, the first edge surface E1, the second edge surface E2, the third edge surface E3, and the fourth edge surface E4 may be positioned at the edges of the first electrode 120.

Further, the first edge surface E1 and the second edge surface E2 may be disposed to be spaced apart from each other in the third direction (the Z-axis direction) and may face each other. The third edge surface E3 and the fourth edge surface E4 may be positioned between the first edge surface E1 and the second edge surface E2 and disposed to be spaced apart from each other in the second direction (the Y-axis direction). Further, the third edge surface E3 and the fourth edge surface E4 may face each other.

In addition, the first conductive semiconductor structure 130 and the second conductive semiconductor structure 140 may disposed to be spaced apart from each other on the first electrode 120.

In addition, as described above, since the first conductive bonding member is applied on the first electrode 120, the first conductive bonding member may be positioned between the first conductive semiconductor structure 130 and the first electrode 120 or between the second conductive semiconductor structure 140 and the first electrode 120.

The first conductive bonding member IE1 may include the first arrangement portions DP1 overlapping the plurality of semiconductor structures 130 and 140 in the vertical direction or the first direction (the X-axis direction), and the first barrier portion BR1 disposed between the plurality of semiconductor structures 130 and 140 or disposed between the first arrangement portions S 1. That is, each of the plurality of semiconductor structures 130 and 140 may be disposed on the first arrangement portion DP1. Furthermore, the first conductive bonding member IE1 further includes a first edge portion ER1 positioned at the outside of the plurality of semiconductor structures.

Further, the plurality of semiconductor structures 130 and 140 may include outer surfaces SF1 and SF2. In addition, the semiconductor structures 130 and 140 may include outer surfaces SF1 facing each other and outer surfaces SF2 not facing each other on the first electrode 120.

In an embodiment, the first conductive bonding member IE1 may include the first edge portion ER1 positioned between the edges of the plurality of semiconductor structures 130 and 140 and the edge of the first electrode 120 except for the first arrangement portion DP1, and the first barrier portion BR1 positioned between the outer surfaces SF1 of the plurality of semiconductor structures 130 and 140 facing each other.

That is, the first barrier portion BR1 and the first edge portion ER1 may be positioned between the outer surfaces SF1 and SF2 of the plurality of semiconductor structures 130 and 140 and the first edge surface E1 to the fourth edge surface E4 of the first electrode 120.

Further, the first edge portion ER1 may be positioned between the outer surfaces SF2 of the semiconductor structures 130 and 140 not facing each other and the first edge surface E1 to the fourth edge surface E4 of the first electrode 120 on the first electrode 120. In addition, the first barrier portion BR1 may be positioned between the outer surfaces SF1 of the semiconductor structures 130 and 140 facing each other on the first electrode 120. For example, the first barrier portion BR1 may be positioned between the outer surfaces SF1 facing each other and spaced apart in the second direction (the Y-axis direction).

In an embodiment, a distance l3 between the outer surfaces SF1 of the plurality of semiconductor structures 130 and 140 facing each other may be greater than a distance l4 between the outer surfaces SF2 of the plurality of semiconductor structures 130 and 140 not facing each other and the first edge surface E1 to the fourth edge surface E4 of the first electrode 120 adjacent to the outer surface SF2.

The description of the above-described first conductive bonding member IE1 may be correspondingly applied to the second conductive bonding member IE2. That is, the descriptions of the above-described first barrier portion BR1, first arrangement portion DP1, first edge portion ER1 may be applied to the second barrier portion BR2, the second arrangement portion DP2, and a second edge portion ER2 of the second conductive bonding member IE2.

Referring to FIG. 8 and the following Table 1, in the thermoelectric element according to the embodiment, a ratio of a thickness h1 and a maximum thickness h2 of the first conductive bonding member IE1 between the semiconductor structures 130 and 140 and the first electrode 120 may be 1:2.5 or less. That is, the thickness h2 of the first barrier portion BR1 may be 2.5 times or less the thickness h1 of the first arrangement portion DP1. When the thickness h2 of the first barrier portion BR1 is greater than 2.5 times the thickness h1 of the first arrangement portion DP1, a problem in that power generation performance and reliability are lowered occurs.

**[Table 1]**

| | | | | |
|---|---|---|---|---|
| h1:h2 | 1:2 | 1:2.5 | 1:3 | 1:3.5 |
| Power generation performance [W] | 25.1 | 24.8 | 23.6 | 22.8 |
| Reliability [hr] | 1,000 or more | 1,000 or more | 887 | 278 |

Here, the power generation performance was measured when a temperature of a high-temperature portion was 150 °C and a temperature of a low-temperature portion was 35 °C. Further, reliability indicates the measured time (hr) when a resistance change rate of the thermoelectric element is 10% or more in the case in which the temperature of the high-temperature portion is 200 °C and the temperature of the low-temperature portion is 35 °C. Further, in the thermoelectric element according to the embodiment, the thickness h2 of the first barrier portion BR1 may be different from the thickness h1 of the first arrangement portion DP1. For example, in the first conductive bonding member IE1, the thickness h1 of the first arrangement portion DP1 may be smaller than the thickness h2 of the first barrier portion BR1. Specifically, the thickness h2 of the first barrier portion BR1 may be the maximum thickness. Accordingly, the first conductive bonding member IE1 may be convex toward the second electrode 150 facing the first electrode 120 in a second region S2. Alternatively, the first barrier portion BR1 of the first conductive bonding member IE1 may have the first convex portion CV1 on the first support SP1, and the first convex portion CV1 may protrude or be convex in a direction toward the first insulating part from the first substrate. Specifically, the first conductive bonding member IE1 may have a maximum thickness at the first barrier portion BR1. That is, the first conductive bonding member IE1 may be more convex toward the second electrode 150 at the first barrier portion BR1 than at the first edge portion ER1. Accordingly, the maximum thickness of the first conductive bonding member IE1 at the first edge portion ER1 may be smaller than the maximum thickness at the first barrier portion BR1. Accordingly, a portion where the first conductive bonding member IE1 is bonded to the first blocking layer LP at the first barrier portion BR1 may be positioned on a portion where the first conductive bonding member IE1 is bonded to the first blocking layer LP at the first edge portion ER1.

Further, in the first conductive bonding member IE1, an uppermost surface of the first barrier portion BR1 may be positioned on the first blocking layer LP. However, the first conductive bonding member IE1 may come into contact with the bottom surface and portions of the side surfaces of the first blocking layer LP. According to this configuration, the first conductive bonding member IE1 may be blocked from coming into contact with the side surfaces of the semiconductor structures 130 and 140 through the side surface of the first blocking layer LP. Accordingly, a problem in that some components (for example, tin (Sn)) of the first conductive bonding member IE1 pass through the first blocking layer LP and move to the above-described semiconductor structures 130 and 140 and thus the bonding area between the first blocking layer LP and the semiconductor structures 130 and 140 is reduced may be blocked. That is, a problem in that at a high temperature, the first conductive bonding member IE1 comes into contact with portions of the semiconductor structures 130 and 140 along the side surfaces of the first blocking layer LP, and thus the components of the semiconductor structures (for example, BiTe) and the components (for example, Sn) of the first conductive bonding member are bonded to each other may be prevented. Accordingly, since the first conductive bonding member does not move or migrate to the side surfaces of the semiconductor structures, a problem in that a bonding area between the first blocking layer and the first conductive bonding member is reduced may be blocked. Accordingly, the electrical reliability of the thermoelectric element according to the embodiment may be improved.

Further, in the first conductive bonding member IE1, an uppermost surface of the first edge portion ER1 may be positioned under the first blocking layer LP. Furthermore, the first conductive bonding member IE1 comes into contact with only portions of the side surfaces of the first blocking layer LP at the first edge portion ER1.

Further, the first insulating part 170a according to the embodiment may include a plurality of recesses RS1 and RS2 which are convex toward the first substrate 110 or concave in a downward direction. For example, the first insulating part 170a may include a first recess RS1 and a second recess R2.

The first electrode 120 may be disposed in the first recess RS1. That is, the first recess RS1 may overlap the first electrode 120 in the vertical direction.

The second recess RS2 may be disposed around the first recess RS1. That is, the second recess RS2 may not vertically overlap the first electrode 120. Furthermore, the second recess RS2 may not vertically overlap the first convex portion CV1.

In an embodiment, a first distance L1 between a bottom surface RS1f of the first recess RS1 and the first substrate 110 may be smaller than a second distance L2 between the second recess RS2 and the first substrate 110. According to this configuration, the bonding strength and insulating property between the first electrode 120 and the first insulating layer 170a may be improved. In other words, the reliability of the thermoelectric element may be improved.

Furthermore, a thickness of the first convex portion CV1 may be smaller than a depth of the second recess RS2. In an embodiment, the depth of the recess may correspond to a length of a side surface of the recess in the vertical direction. Alternatively, the depth of the recess may be the length of the recess in the vertical direction. In an embodiment, the depth of the first recess may be a distance from an upper surface of the first insulating part 170a to the bottom surface RS1f of the first recess RS1 in the vertical direction, and the depth of the second recess may be a distance from the upper surface of the first insulating part 170a to a bottom surface RS2f of the second recess RS2 in the vertical direction. Further, a depth of a third recess RS3 may be a distance from a lower surface of the second insulating part 170b to an upper surface of the third recess RS3 in the vertical direction, and a depth of a fourth recess RS4 may be a distance from the lower surface of the second insulating part 170b to an upper surface of the fourth recess RS4. In addition, the thickness of the first barrier portion BR1 may be greater than or equal to the thickness of the first arrangement portion DP1.

In addition, in an embodiment, as shown in FIG. 5, the second insulating part 170b may include a plurality of recesses RS3 and RS4 which are convex toward the second substrate 160 or concave in an upward direction. For example, the second insulating part 170b may include the third recess RS3 and the second recess R4.

The second electrode 150 may be disposed in the third recess RS3. That is, the third recess RS3 may overlap the second electrode 150 in the vertical direction. Furthermore, the fourth recess RS4 may not vertically overlap the second convex portion CV2.

The fourth recess RS4 may be disposed around the third recess RS4. That is, the third recess RS3 may not vertically overlap the second electrode 150.

In an embodiment, a third distance between the upper surface of the third recess RS3 and the second substrate 160 may be smaller than a fourth distance between the fourth recess RS4 and the second substrate 160. According to this configuration, the bonding strength and insulating property between the second electrode 150 and the second insulating layer 170b may be improved. In other words, the reliability of the thermoelectric element may be improved.

The above-described first recess RS1 to fourth recess RS4 may have various shapes. For example, in the first to fourth recesses RS1 to RS4, all of the side surfaces and the bottom surfaces (or upper surfaces) surrounded by the side surfaces may have curvature.

Furthermore, a thickness of the second convex portion CV2 may be smaller than the depth of the third recess RS3. In an embodiment, the depth of the recess may correspond to the length of the side surface of the recess in the vertical direction. Alternatively, the depth of the recess may be the length of the recess in the vertical direction. Further, a thickness of the second barrier portion BR2 may be greater than or equal to the thickness of the second arrangement portion DP2.

In addition, the first barrier portion BR1 may vertically overlap the fourth recess RS4. In an embodiment, the depth of the fourth recess RS4 may be greater or smaller than the thickness of the first barrier portion BR1. For example, the depth of the fourth recess RS4 may be greater than the thickness of the first barrier portion BR1.

Further, the depth of the second recess RS2 and the depth of the fourth recess RS4 may be different from each other.

In addition, the first barrier portion BR1 and the second barrier portion BR2 may be displaced from each other. In an embodiment, the first barrier portion BR1 and the second barrier portion BR2 may not vertically overlap each other.

Referring to FIG. 9, the first insulating part 170a may be disposed to be spaced a predetermined distance apart from the edge of the first substrate 110 on the first substrate 110. Alternatively, the first insulating part 170a may be positioned on the entire upper surface of the first substrate 110.

Further, the first conductive bonding member IE1 between the plurality of semiconductor structures may be positioned on the second blocking layer EP, and the upper surface of the first conductive bonding member IE1 may have curvature.

Like the above description, a maximum height of the first conductive bonding member IE1 at the first barrier portion BR1 may be greater than a maximum height of the first conductive bonding member IE1 at the first edge portion ER1.

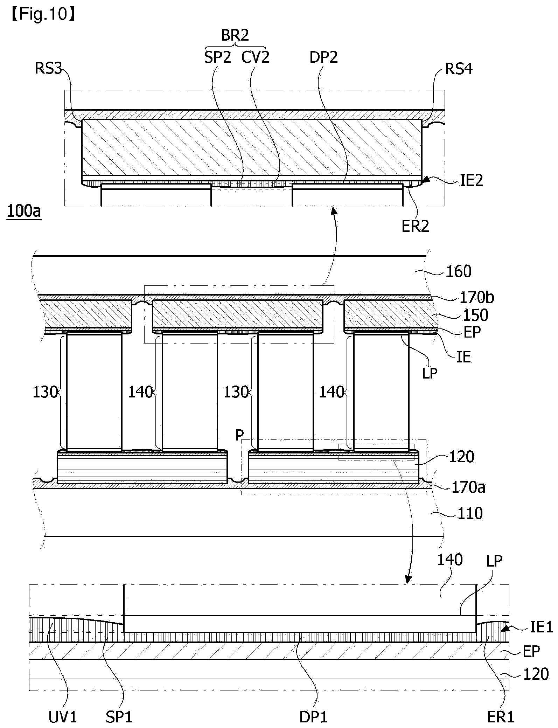

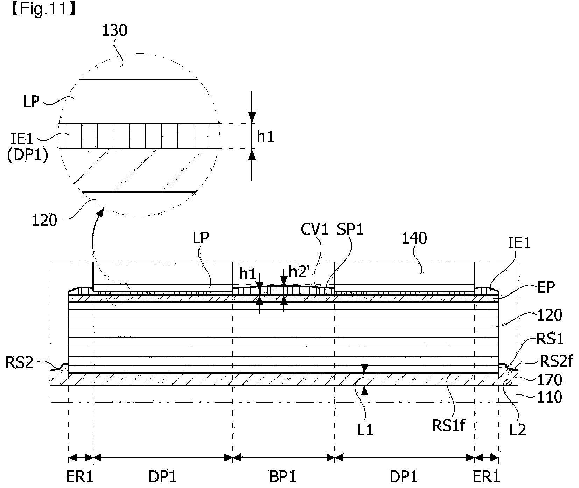

FIG. 10 is a cross-sectional view of a thermoelectric element according to another embodiment, and FIG. 11 is an enlarged view of portion K in FIG. 10.

Referring to FIGS. 10 and 11, a thermoelectric element 100a according to another embodiment may include a first substrate 110, a first insulating part 170a (or 'lower insulating part') disposed on the first substrate 110, first electrodes 120 disposed on the first insulating part 170a, a plurality of semiconductor structures 130 and 140 disposed on the first electrodes 120, second electrodes 150 disposed on the plurality of semiconductor structures 130 and 140, a second insulating part 170b (or 'upper insulating part') disposed on the second electrodes 150, and a second substrate 160 disposed on the second insulating part 170b.

In an embodiment, the plurality of semiconductor structures 130 and 140 may include a plurality of first conductive semiconductor structures (N-type thermoelectric legs) and second conductive semiconductor structures (P-type thermoelectric legs). Further, the first conductive semiconductor structure 130 may be any one of the N-type thermoelectric leg and the P-type thermoelectric leg, and the second conductive semiconductor structure 140 may be the other of the N-type thermoelectric leg and the P-type thermoelectric leg. Hereinafter, description will be made based on the first conductive semiconductor structure as a P-type thermoelectric leg, and the second conductive semiconductor structure as an N-type thermoelectric leg.

Further, descriptions of the first substrate 110, the first electrodes 120, the first conductive semiconductor structures or the P-type thermoelectric legs 130, the second conductive semiconductor structures or the N-type thermoelectric legs 140, the second electrodes 150, and the second substrate 160 in FIGS. 1 to 4 may be equally applied to the first substrate 110, the plurality of semiconductor structures 130 and 140, the second electrodes 150, and the second substrate 160.

Furthermore, although not shown in the drawings, a heat sink may be further disposed on the first substrate 110 or the second substrate 160, and a sealing member may be further disposed between the first substrate 110 and the second substrate 160.

The thermoelectric element 100a according to another embodiment may include the first insulating part 170a disposed on the first substrate 110 and the second insulating part 170b disposed under the second substrate 160. Further, the first insulating part 170a may be disposed on lower surfaces of the first electrodes 120 and the second insulating part 170b may be disposed on upper surfaces of the second electrodes 150. Furthermore, the first substrate 110 may be disposed on a lower surface of the first insulating part 170a, and the second substrate 160 may be disposed on an upper surface of the second insulating part 170b.

Further, the thermoelectric element 100a according to another embodiment may further include first blocking layers LP disposed at both ends of the plurality of semiconductor structures 130 and 140, a second blocking layer EP disposed on the first electrode 120 or the second electrode 150, and a first conductive bonding member IE1 and a second conductive bonding member IE2 disposed between the first blocking layers LP and the second blocking layer EP. The first conductive bonding member may be disposed between the plurality of semiconductor structures 130 and 140 and the first electrodes 120, and the second conductive bonding member IE2 may be disposed between the plurality of semiconductor structures 130 and 140 and the second electrodes 150. Alternatively, the first conductive bonding member IE1 may be disposed on the first electrodes 120 and the second conductive bonding member IE2 may be disposed under the second electrodes 150.

Further, the first blocking layers LP may be disposed at both ends of the plurality of semiconductor structures 130 and 140. In an embodiment, the first blocking layers LP may be positioned at both ends of the first conductive semiconductor structure 130 and both ends of the second conductive semiconductor structure 140. Accordingly, the first blocking layers LP may come into contact with the plurality of semiconductor structures 130 and 140.

Further, the first blocking layers LP may be positioned between the first electrodes 120 and the plurality of semiconductor structures 130 and 140 and between the second electrodes 150 and the plurality of semiconductor structures 130 and 140, and thus may come into contact with the electrodes 120 or the second electrodes 150.

The second blocking layer EP may be positioned on the first electrode 120 or the second electrode 150. In an embodiment, one surface of the second blocking layer EP may come into contact with the first electrode 120. Further, the second blocking layer EP may be positioned between the first electrode 120 and the semiconductor structures 130 and 140 or between the first electrode 120 and the first conductive bonding member IE1. In the embodiment, the other surface of the second blocking layer EP may come into contact with the first conductive bonding member IE1.

The first conductive bonding member IE1 may be disposed between the first blocking layer LP and the second blocking layer EP to couple the first blocking layer LP and the second blocking layer EP. Further, the first conductive bonding member IE1 may be positioned between the semiconductor structures 130 and 140 and the first electrode 120, and the second conductive bonding member IE may be positioned between the semiconductor structures 130 and 140 and the second electrode 150. Accordingly, the first conductive bonding member IE1 may couple the semiconductor structures 130 and 140 and the first electrode 120, and the second conductive bonding member IE2 may couple the semiconductor structures 130 and 140 and the second electrode 150.

Further, the first conductive bonding member IE1 and the second conductive bonding member IE2 may each include a metal component. For example, the first conductive bonding member IE1 may include tin (Sn). Further, the first conductive bonding member IE1 may have conductivity like the first and second blocking layers LP and EP.

In an embodiment, in the first conductive bonding member IE1, a height at regions outside edges of the semiconductor structures and a height at lower regions (regions overlapping in the vertical direction) of the semiconductor structures 130 and 140 may be different from each other. For example, in the first conductive bonding member IE1, the height at the regions outside the edges of the semiconductor structures may be greater than the height at the lower regions (regions overlapping in the vertical direction) of the semiconductor structures 130 and 140.

In an embodiment, the first conductive bonding member IE2 may include first arrangement portions DP1 on which the plurality of semiconductor structures 130 and 140 are respectively disposed, and a first barrier portion BR1 disposed between the first arrangement portions DP1 or between the semiconductor structures.

Further, the first barrier portion BR1 may include a first support SP1 having the same thickness h1 as the first arrangement portion DP1, and a first convex portion CV1 which is disposed on the first support SP1 and convex in a direction toward the first insulating part 170a from the first substrate 110.

In addition, in the second conductive bonding member IE2, a thickness (a thickness of a second edge portion ER2) at regions outside edges of the semiconductor structures and a thickness (a thickness of a second support SP2) at upper regions (regions overlapping in the vertical direction) of the semiconductor structures 130 and 140 may be different from each other. For example, in the second conductive bonding member IE2, the thickness of the second edge portion ER2 may be greater than the thickness of the second support SP2.

In an embodiment, the second conductive bonding member IE2 may include second arrangement portions DP2 on which the plurality of semiconductor structures 130 and 140 are respectively disposed, and a second barrier portion BR2 disposed between the second arrangement portions DP2 or between the semiconductor structures 130 and 140.

Further, the second barrier portion BR2 may include a second support SP2 having the same thickness h1 as the second arrangement portion DP2, and a second convex portion CV2 which is disposed under the second support SP2 and convex in a direction toward the second insulating part 170b from the second substrate 160.

In the present embodiment, descriptions of the first substrate 110, the first electrodes 120, the semiconductor structures 130 and 140, the second electrodes 150, the second substrate 160, the first insulating part 170a, the first blocking layer LP, the second blocking layer EP, and the first conductive bonding member IE1 in the thermoelectric element according to the above-described embodiment, may be equally applied except for portions having differences.

Furthermore, in the first conductive bonding member IE1, an uppermost surface of the first barrier portion BR1 may be positioned at the same level as or under the upper surface of the first blocking layer LP. Accordingly, during driving or under a predetermined environment, even when the first conductive bonding member IE1 in the first barrier portion BR1 moves toward the semiconductor structures 130 and 140 adjacent thereto, the first conductive bonding member IE1 and the semiconductor structures 130 and 140 may be prevented from coming into contact with each other. Accordingly, a problem in that the first conductive bonding member IE1 comes into contact with portions of the semiconductor structures 130 and 140 along the side surfaces of the first blocking layer LP, and thus the components of the semiconductor structures (for example, BiTe) and the components (for example, Sn) of the first conductive bonding member are bonded to each other may be prevented. Accordingly, since the first conductive bonding member is prevented from moving or migrating to the side surfaces of the semiconductor structures, a problem in that a bonding area between the first blocking layer and the first conductive bonding member is reduced may be blocked. Accordingly, the electrical reliability of the thermoelectric element according to the embodiment may be improved.

Further, a lowermost surface of the second conductive bonding member IE2 at the second barrier portion BR2 may be positioned at the same level as or under the lower surface of the first blocking layer LP which is positioned at an upper portion or is between the second conductive bonding member IE2 and the plurality of semiconductor structures 130 and 140.

In the present specification, the above-described thermoelectric element may be applied to a thermoelectric device. The thermoelectric device may include the thermoelectric element and a heat sink bonded to the thermoelectric element.

Further, the thermoelectric device may be used for a power generation device, a power generation system including the power generation device, or the like. For example, the power generation system may include the power generation device and a fluid pipe, and a fluid introduced into the fluid pipe may be a heat source generated from an engine of an automobile, a ship, or the like, a power plant, a steel mill, or the like. However, the present invention is not limited to this content. Further, a temperature of a fluid discharged from the fluid pipe is lower than a temperature of the fluid introduced into the fluid pipe. For example, the temperature of the fluid introduced into the fluid pipe may be 100 °C or more, preferably 200 °C or more, and more preferably, 220 °C to 250 °C, but is not limited thereto, and it may be variously applied according to temperature differences between a low-temperature portion and a high-temperature portion of the thermoelectric element. Accordingly, the thermoelectric element according to the embodiment of the present invention may be applied to a device for power generation, a device for cooling, a device for heating, or the like.

Although one preferable embodiment of the present invention is described above, those skilled in the art may variously modify and change the present invention within the scope of the present invention disclosed in the following claims.

## Claims

1. A thermoelectric element comprising:
a first electrode (120);
a first conductive bonding member (IE1) disposed on the first electrode (120);
a plurality of semiconductor structures (130, 140) disposed on the first conductive bonding member (IE1); and
a first blocking layer (LP) positioned between the first electrode (120) and each semiconductor structure (130, 140),
wherein the first conductive bonding member (IE1) includes first arrangement portions (DP1) on which the plurality of semiconductor structures (130, 140) are respectively arranged, and a first barrier portion (BR1) positioned between the first arrangement portions (DP1), and a first edge portion (ER1) positioned outside of the plurality of semiconductor structures (130, 140) facing each other on the first electrode (120), and
wherein the first edge portion (ER1) is in contact with a part of a side surface of the first blocking layer (LP).

2. The thermoelectric element of claim 1, further comprising:
a first insulating part (170a) disposed on a lower surface of the first electrode (120); and
a first substrate (110) disposed on a lower surface of the first insulating part (170a).

3. The thermoelectric element of claim 2, wherein:
the first insulating part (170a) includes a plurality of recesses (RS1, RS2) which are concave toward the first substrate (110) from an upper surface thereof; and
the plurality of recesses (RS1, RS2) include a first recess in which the first electrode (120) is disposed and a second recess disposed around the first recess.

4. The thermoelectric element of claim 3, wherein a first distance between a bottom surface of the first recess and the first substrate (110) is smaller than a second distance between a bottom surface of the second recess and the first substrate (110).

5. The thermoelectric element of claim 4, wherein:
the first barrier portion (BR1) of the first conductive bonding member (IE1) includes a first support having the same thickness as the first arrangement portion, and a first convex portion which is disposed on the first support and convex in a direction toward the first insulating part from the first substrate (110); and
the second recess and the first convex portion do not vertically overlap.

6. The thermoelectric element of claim 5, wherein:
a thickness of the first convex portion is smaller than a depth of the second recess; and
a thickness of the first barrier portion (BR1) is greater than or equal to a thickness of the first arrangement portion.

7. The thermoelectric element of claim 5, further comprising:
a plurality of second electrodes respectively disposed on the plurality of semiconductor structures (130, 140);
a second insulating part disposed on the plurality of second electrodes; and
a second substrate disposed on the second insulating part.

8. The thermoelectric element of claim 7, wherein:
the second insulating part includes a third recess in which each of the plurality of second electrodes is disposed, and a fourth recess disposed around the third recess;
the third recess and the fourth recess are concave toward the second substrate from a lower surface of the second insulating part; and
the first barrier portion (BR1) and the fourth recess vertically overlap.

9. The thermoelectric element of claim 8, wherein a depth of the fourth recess is greater than a thickness of the first barrier portion.

10. The thermoelectric element of claim 8, wherein a depth of the second recess and a depth of the fourth recess are different from each other.

11. The thermoelectric element of claim 1, wherein a thickness of the first barrier portion (BR1) is 2.5 times or less a thickness of each of the first arrangement portions (DP1).

12. The thermoelectric element of claim 11, wherein the first arrangement portions (DP1) are defined by the portions of the first conductive bonding member (IE1) sandwiched between the first electrode (120) and each of the plurality of semiconductor structures (130, 140).

13. The thermoelectric element of claim 1, wherein the plurality of semiconductor structures (130, 140) include outer surfaces facing each other.

14. The thermoelectric element of claim 13, wherein the first barrier portion (BR1) and the first edge portion (ER1) are positioned between the outer surfaces of the plurality of semiconductor structures (130, 140).

15. The thermoelectric element of claim 13, wherein the first barrier portion (BR1) is positioned between the outer surfaces of the semiconductor structures (130, 140) facing each other on the first electrode (120).

## Patentansprüche

1. Thermoelektrisches Element, umfassend:
eine erste Elektrode (120);
ein erstes leitfähiges Verbindungselement (IE1), das auf der ersten Elektrode (120) angeordnet ist;
eine Vielzahl von Halbleiterstrukturen (130, 140), die auf dem ersten leitfähigen Verbindungselement (IE1) angeordnet sind; und
eine erste Sperrschicht (LP), die zwischen der ersten Elektrode (120) und jeder Halbleiterstruktur (130, 140) positioniert ist,
wobei das erste leitfähige Verbindungselement (IE1) erste Anordnungsabschnitte (DP1), auf denen die Vielzahl von Halbleiterstrukturen (130, 140) jeweils angeordnet sind, und einen ersten Barriereabschnitt (BR1), der zwischen den ersten Anordnungsabschnitten (DP1) positioniert ist, und einen ersten Randabschnitt (ER1), der außerhalb der Vielzahl von Halbleiterstrukturen (130, 140) positioniert ist, die einander auf der ersten Elektrode (120) gegenüberliegen, aufweist, und wobei der erste Randabschnitt (ER1) mit einem Teil einer Seitenfläche der ersten Sperrschicht (LP) in Kontakt steht.

2. Thermoelektrisches Element nach Anspruch 1, ferner umfassend:
ein erstes Isolierteil (170a), das auf einer Unterseite der ersten Elektrode (120) angeordnet ist; und
ein erstes Substrat (110), das auf einer Unterseite des ersten Isolierteils (170a) angeordnet ist.

3. Thermoelektrisches Element nach Anspruch 2, wobei:
das erste Isolierteil (170a) eine Vielzahl von Aussparungen (RS1, RS2) aufweist, die von einer Oberseite desselben in Richtung des ersten Substrats (110) konkav sind, und
die Vielzahl von Aussparungen (RS1, RS2) eine erste Aussparung, in der die erste Elektrode (120) angeordnet ist, und eine zweite Aussparung, die um die erste Aussparung herum angeordnet ist, umfasst.

4. Thermoelektrisches Element nach Anspruch 3, wobei ein erster Abstand zwischen einer Bodenfläche der ersten Aussparung und dem ersten Substrat (110) kleiner ist als ein zweiter Abstand zwischen einer Bodenfläche der zweiten Aussparung und dem ersten Substrat (110).

5. Thermoelektrisches Element nach Anspruch 4, wobei:
der erste Barriereabschnitt (BR1) des ersten leitfähigen Verbindungselements (IE1) einen ersten Träger mit der gleichen Dicke wie der erste Anordnungsabschnitt und einen ersten konvexen Abschnitt, der auf dem ersten Träger angeordnet ist und in einer Richtung vom ersten Substrat (110) zum ersten Isolierteil hin konvex ist, aufweist; und
die zweite Aussparung und der erste konvexe Abschnitt einander vertikal nicht überlappen.

6. Thermoelektrisches Element nach Anspruch 5, wobei:
eine Dicke des ersten konvexen Abschnitts kleiner ist als eine Tiefe der zweiten Aussparung; und
eine Dicke des ersten Barriereabschnitts (BR1) größer oder gleich einer Dicke des ersten Anordnungsabschnitts ist.

7. Thermoelektrisches Element nach Anspruch 5, ferner umfassend:
eine Vielzahl von zweiten Elektroden, die jeweils auf der Vielzahl von Halbleiterstrukturen (130, 140) angeordnet sind;
ein zweites Isolierteil, das auf der Vielzahl von zweiten Elektroden angeordnet ist; und
ein zweites Substrat, das auf dem zweiten Isolierteil angeordnet ist.

8. Thermoelektrisches Element nach Anspruch 7, wobei:
das zweite Isolierteil eine dritte Aussparung, in der jede der Vielzahl von zweiten Elektroden angeordnet ist, und eine vierte Aussparung, die um die dritte Aussparung herum angeordnet ist, aufweist;
die dritte Aussparung und die vierte Aussparung von einer Unterseite des zweiten Isolierteils in Richtung des zweiten Substrats konkav sind; und
der erste Barriereabschnitt (BR1) und die vierte Aussparung einander vertikal überlappen.

9. Thermoelektrisches Element nach Anspruch 8, wobei eine Tiefe der vierten Aussparung größer ist als eine Dicke des ersten Barriereabschnitts.

10. Thermoelektrisches Element nach Anspruch 8, wobei eine Tiefe der zweiten Aussparung und eine Tiefe der vierten Aussparung sich voneinander unterscheiden.

11. Thermoelektrisches Element nach Anspruch 1, wobei eine Dicke des ersten Barriereabschnitts (BR1) das 2,5-fache oder weniger einer Dicke von jedem der ersten Anordnungsabschnitte (DP1) beträgt.

12. Thermoelektrisches Element nach Anspruch 11, wobei die ersten Anordnungsabschnitte (DP1) durch die Abschnitte des ersten leitfähigen Verbindungselements (IE1) definiert sind, die sandwichartig zwischen der ersten Elektrode (120) und jeder der Vielzahl von Halbleiterstrukturen (130, 140) angeordnet sind.

13. Thermoelektrisches Element nach Anspruch 1, wobei die Vielzahl von Halbleiterstrukturen (130, 140) einander zugewandte Außenflächen aufweisen.

14. Thermoelektrisches Element nach Anspruch 13, wobei der erste Barriereabschnitt (BR1) und der erste Randabschnitt (ER1) zwischen den Außenflächen der Vielzahl von Halbleiterstrukturen (130, 140) positioniert sind.

15. Thermoelektrisches Element nach Anspruch 13, wobei der erste Barriereabschnitt (BR1) zwischen den Außenflächen der einander auf der ersten Elektrode (120) gegenüberliegenden Halbleiterstrukturen (130, 140) positioniert ist.

## Revendications

1. Un élément thermoélectrique comprenant :
une première électrode (120) ;
un premier élément de liaison conducteur (IE1) disposé sur la première électrode (120) ;
une pluralité de structures semi-conductrices (130, 140) disposées sur le premier élément de liaison conducteur (IE1) ; et
une première couche de blocage (LP) positionnée entre la première électrode (120) et chaque structure semi-conductrice (130, 140),
dans lequel le premier élément de liaison conducteur (IE1) comprend des premières portions d'agencement (DP1) sur lesquelles la pluralité de structures semi-conductrices (130, 140) sont respectivement agencées, et une première portion de barrière (BR1) positionnée entre les premières portions d'agencement (DP1), et une première portion de bord (ER1) positionnée à l'extérieur de la pluralité de structures semi-conductrices (130, 140) se faisant face sur la première électrode (120), et dans lequel la première portion de bord (ER1) est en contact avec une partie d'une surface latérale de la première couche de blocage (LP).

2. L'élément thermoélectrique selon la revendication 1, comprenant en outre :
une première partie isolante (170a) disposée sur une surface inférieure de la première électrode (120) ; et
un premier substrat (110) disposé sur une surface inférieure de la première partie isolante (170a).

3. L'élément thermoélectrique selon la revendication 2, dans lequel :
la première partie isolante (170a) comprend une pluralité d'évidements (RS1, RS2) qui sont concaves vers le premier substrat (110) depuis une surface supérieure de celle-ci, et
la pluralité d'évidements (RS1, RS2) comprend un premier évidement dans lequel la première électrode (120) est disposée et un deuxième évidement disposé autour du premier évidement.

4. L'élément thermoélectrique selon la revendication 3, dans lequel une première distance entre une surface de fond du premier évidement et le premier substrat (110) est inférieure à une deuxième distance entre une surface de fond du deuxième évidement et le premier substrat (110).

5. L'élément thermoélectrique selon la revendication 4, dans lequel :
la première portion de barrière (BR1) du premier élément de liaison conducteur (IE1) comprend un premier support ayant la même épaisseur que la première portion d'agencement, et une première portion convexe qui est disposée sur le premier support et convexe dans une direction vers la première partie isolante depuis le premier substrat (110) ; et
le deuxième évidement et la première portion convexe ne se chevauchent pas verticalement.

6. L'élément thermoélectrique selon la revendication 5, dans lequel :
une épaisseur de la première portion convexe est inférieure à une profondeur du deuxième évidement ; et
une épaisseur de la première portion de barrière (BR1) est supérieure ou égale à une épaisseur de la première portion d'agencement.

7. L'élément thermoélectrique selon la revendication 5, comprenant en outre :
une pluralité de deuxièmes électrodes respectivement disposées sur la pluralité de structures semi-conductrices (130, 140) ;
une deuxième partie isolante disposée sur la pluralité de deuxièmes électrodes ; et
un deuxième substrat disposé sur la deuxième partie isolante.

8. L'élément thermoélectrique selon la revendication 7, dans lequel :
la deuxième partie isolante comprend un troisième évidement dans lequel chacune de la pluralité de deuxièmes électrodes est disposée, et un quatrième évidement disposé autour du troisième évidement ;
le troisième évidement et le quatrième évidement sont concaves vers le deuxième substrat depuis une surface inférieure de la deuxième partie isolante ; et
la première portion de barrière (BR1) et le quatrième évidement se chevauchent verticalement.

9. L'élément thermoélectrique selon la revendication 8, dans lequel une profondeur du quatrième évidement est supérieure à une épaisseur de la première portion de barrière.

10. L'élément thermoélectrique selon la revendication 8, dans lequel une profondeur du deuxième évidement et une profondeur du quatrième évidement sont différentes l'une de l'autre.

11. L'élément thermoélectrique selon la revendication 1, dans lequel une épaisseur de la première portion de barrière (BR1) est égale à 2,5 fois ou moins une épaisseur de chacune des premières portions d'agencement (DP1).

12. L'élément thermoélectrique selon la revendication 11, dans lequel les premières portions d'agencement (DP1) sont définies par les portions du premier élément de liaison conducteur (IE1) prises en sandwich entre la première électrode (120) et chacune de la pluralité de structures semi-conductrices (130, 140).

13. L'élément thermoélectrique selon la revendication 1, dans lequel la pluralité de structures semi-conductrices (130, 140) comprend des surfaces externes se faisant face.

14. L'élément thermoélectrique selon la revendication 13, dans lequel la première portion de barrière (BR1) et la première portion de bord (ER1) sont positionnées entre les surfaces externes de la pluralité de structures semi-conductrices (130, 140).

15. L'élément thermoélectrique selon la revendication 13, dans lequel la première portion de barrière (BR1) est positionnée entre les surfaces externes de la pluralité de structures semi-conductrices (130, 140) se faisant face sur la première électrode (120).
